# EUROPEAN PATENT SPECIFICATION

(11) **EP 3 588 585 B1**
(45) Date of publication and mention of the grant of the patent: **22.02.2023**
(21) Application number: 18760676.9
(22) Date of filing: 28.02.2018
(51) Int. Cl.: H01L 31/0224, H01L 31/068, H01L 31/18

(54) **P-TYPE PERC DOUBLE-SIDED SOLAR CELL, ASSEMBLY THEREOF, SYSTEM THEREOF AND PREPARATION METHOD THEREFOR**
DOPPELSEITIGE PERC-SOLARZELLE VOM P-TYP, ANORDNUNG DAFÜR, SYSTEM DAFÜR UND HERSTELLUNGSVERFAHREN DAFÜR
CELLULE SOLAIRE BIFACIALE DU TYPE PERC DE TYPE P, SON ENSEMBLE, SON SYSTÈME ET SON PROCÉDÉ DE PRÉPARATION

(30) Priority: 03.03.2017 CN 201710122418
(43) Date of publication of application: 01.01.2020
(73) Proprietor: Guangdong Aiko Solar Energy Technology Co., Ltd., Foshan, Guangdong 528000 (CN); Zhejiang Aiko Solar Energy Technology Co., Ltd, Yiwu, Zhejiang 322009 (CN)
(72) Inventor: LIN, Kang-Cheng, Guangdong 528000 (CN); FANG, Jiebin, Guangdong 528000 (CN); CHEN, Gang, Guangdong 528000 (CN)
(74) Representative: Steinbauer, Florian
(86) International application number: PCT/CN2018/077585
(87) International publication number: WO 2018/157821

(56) References cited:
- WO-A2-2011/060764
- CN-A- 103 489 934
- CN-A- 105 702 758
- CN-A- 105 810 769
- CN-A- 106 252 445
- CN-A- 106 449 834
- CN-A- 106 876 497
- CN-A- 106 887 475
- CN-A- 107 425 080
- CN-U- 205 335 274
- DE-A1-102014 105 358
- DE-A1-102015 104 236
- DE-U1-202015 004 065
- US-A1- 2016 276 499

## Description

### FIELD OF THE DISCLOSURE

The present invention relates to the field of solar cells, and in particular to a bifacial P-type PERC solar cell, a method of preparing the bifacial P-type PERC solar cell, a solar cell module that employs the bifacial P-type PERC solar cell, and a solar system that employs the bifacial P-type PERC solar cell.

### BACKGROUND OF THE DISCLOSURE

A crystalline silicon solar cell is a device that effectively absorbs solar radiation energy and converts light energy into electrical energy through the photovoltaic effect. When sunlight reaches the p-n junction of a semiconductor, new electron-hole pairs are generated. Under the action of the electric field of the p-n junction, the holes flow from the N zone to the P zone, and the electrons flow from the P zone to the N zone, generating current upon switching on a circuit.

In a conventional crystalline silicon solar cell, surface passivation is basically only performed at the front surface, which involves depositing a layer of silicon nitride on the front surface of the silicon wafer via PECVD to reduce the recombination rate of the minority carriers at the front surface. As a result, the open-circuit voltage and short-circuit current of the crystalline silicon cell can be greatly increased, which leads to an increase of the photoelectric conversion efficiency of the crystalline silicon solar cell. However, as passivation is not provided at the rear surface of the silicon wafer, the increase in photoelectric conversion efficiency is still limited.

The structure of an existing bifacial solar cell is as follows: the substrate is an N-type silicon wafer; when photons from the sun reach the rear surface of the cell, the carriers generated in the N-type silicon wafer pass through the silicon wafer, which has a thickness of about 200 µm; as in an N-type silicon wafer, the minority carriers have a long lifetime and carrier recombination rate is low, some carriers are able to reach the p-n junction at the front surface; the front surface of the solar cell is the main light-receiving surface, and its conversion efficiency accounts for a high proportion of the conversion efficiency of the whole cell; as a result of overall actions at both the front surface and the rear surface, the conversion efficiency of the cell is significantly increased. However, the price of an N-type silicon wafer is high, and the process of manufacturing a bifacial N-type cell is complicated. Therefore, a hotspot for enterprises and researchers is to how to develop a bifacial solar cell with high efficiency and low cost.

On the other hand, in order to meet the ever-rising requirements for the photoelectric conversion efficiency of crystalline silicon cells, the industry has been researching rear-surface passivation techniques for PERC solar cells. Mainstream manufacturers in the industry are mainly developing monofacial PERC solar cells. The present invention combines a highly efficient PERC cell and a bifacial cell to develop a bifacial PERC solar cell that has overall higher photoelectric conversion efficiency.

Bifacial PERC solar cells have higher usage values in the practical applications as they have high photoelectric conversion efficiency while they absorb solar energy on both sides to generate more power. Thus, the present invention aims to provide a bifacial P-type PERC solar cell which is simple to manufacture, low in cost, easy to popularize, and has a high photoelectric conversion efficiency.

DE 20 2015 004 065 U1 discloses a solar cell array is made of a plurality of bifacial PERC solar cells, respectively formed in a semiconductor body, which are electrically interconnected by way of cell connectors. A structured passivation layer is applied on the rear-side surface of the semiconductor body, on which the current collecting rails and contact finger contacting the semiconductor body are provided. A respective cell connector extends at least partially along a longitudinal direction of at least one current collecting rail and electrically contacts this on at least one solder contact via a solder joint. A lateral width of a current collecting rail is at least partially greater than a lateral width of the cell connector covering this current collecting rail.

DE 10 2015 104 236 A1 relates to a photovoltaic solar cell, comprising at least one semiconductor layer, at least one electrically insulating insulation layer and at least one metal contacting structure, wherein the insulation layer is arranged between the semiconductor layer and the contacting structure, and the insulation layer has a plurality of contacting recesses at which the contacting structure forms an electrical contact with the semiconductor layer in a contacting region, and wherein a respective doping region is formed in the semiconductor layer at least at the contacting regions by doping the semiconductor layer with a metal, from which metal the contacting structure is at least partially formed.

DE 10 2014 105 358 A1 relates to a solar cell comprising a substrate with a front-side and a rear-side, wherein at least the front-side receives light; a passivation layer on the rear-side of the substrate; local contact openings, which pass through the passivation layer and partially expose the rear-side of the substrate; and a first rear-side metallization on the passivation layer and in the local contact openings; wherein the plurality of the local contact openings are disposed such that they are completely covered by the first rear-side metallization.

### SUMMARY OF THE DISCLOSURE

An objective to be addressed by the present invention is to provide a bifacial P-type PERC solar cell which is simple in structure, low in cost, easy to popularize, and has a high photoelectric conversion efficiency.

Another objective to be addressed by the present invention is to provide a method of preparing the bifacial P-type PERC solar cell, which is simple in process, low in cost, easy to popularize, and has a high photoelectric conversion efficiency.

Yet another objective to be addressed by the present invention is to provide a bifacial P-type PERC solar cell module which is simple in structure, low in cost, easy to popularize, and has a high photoelectric conversion efficiency.

Still another objective to be addressed by the present invention is to provide a bifacial P-type PERC solar system which is simple in structure, low in cost, easy to popularize, and has a high photoelectric conversion efficiency.

To address the objectives above, the present invention provides a bifacial P-type PERC solar cell which consecutively comprises a rear silver electrode, rear aluminum grid, a rear passivation layer, P-type silicon, an N-type emitter, a front silicon nitride film, and a front silver electrode;
a first laser grooving region is formed in the rear passivation layer with laser grooving, wherein the first laser grooving region is provided below the rear aluminum grid, the rear aluminum grid lines are connected with the P-type silicon via the first laser grooving region, an outer aluminum grid frame is arranged at periphery of the rear aluminum grid lines and is connected with the rear aluminum grid lines and the rear silver electrode;
the first laser grooving region includes a plurality of groups of first laser grooving units arranged horizontally, each group of the first laser grooving units contains one or more first laser grooving bodies arranged horizontally, and the rear aluminum grid lines are perpendicular to the first laser grooving bodies.

As a preferred example of the above embodiments, a second laser grooving region is provided below the outer aluminum grid frame and includes second laser grooving units arranged vertically or horizontally, each group of the second laser grooving units contains one or more second laser grooving bodies arranged vertically or horizontally, and the outer aluminum grid frame is perpendicular to the second laser grooving bodies.

As a preferred example of the above embodiments, the first laser grooving units are arranged in parallel;
in each of the first laser grooving units, the first laser groove bodies are arranged side by side, and in the same horizontal plane or staggered up and down.

As a preferred example of the above embodiments, a spacing between the first laser grooving units is 0.5-50mm;
in each of the first laser grooving units, a spacing between the first laser grooving bodies is 0.5-50mm;
the first laser grooving bodies each have a length of 50-5000µm and a width of 10-500µm;
the number of the rear aluminum grid lines is 30-500;
the rear aluminum grid lines each have a width of 30-500µm and the width of the rear aluminum grid lines is smaller than the length of the first laser grooving bodies.

As a preferred example of the above embodiments, the rear passivation layer includes an aluminum oxide layer and a silicon nitride layer, the aluminum oxide layer is connected with the P-type silicon and the silicon nitride layer is connected with the aluminum oxide layer;
the silicon nitride layer has a thickness of 20-500nm;
the aluminum oxide layer has a thickness of 2-50nm.

Accordingly, the present invention also discloses a method of preparing a bifacial P-type PERC solar cell comprising:
(1) forming textured surfaces at a front surface and a rear surface of a silicon wafer, the silicon wafer being P-type silicon;
(2) performing diffusion on the silicon wafer to form an N-type emitter;
(3) removing phosphosilicate glass on the front surface and peripheral p-n junctions formed during the diffusion;
(4) depositing an aluminum oxide film on the rear surface of the silicon wafer;
(5) depositing a silicon nitride film on the rear surface of the silicon wafer;
(6) depositing a silicon nitride film on the front surface of the silicon wafer;
(7) performing laser grooving in the rear surface of the silicon wafer to form a first laser grooving region, wherein the first laser grooving region includes a plurality of groups of first laser grooving units arranged horizontally, each group of the first laser grooving units contains one or more first laser grooving bodies arranged horizontally;
(8) printing a rear silver busbar electrode on the rear surface of the silicon wafer;
(9) printing aluminum paste in a direction perpendicular to the first laser grooving bodies on the rear surface of the silicon wafer to obtain rear aluminum grid, the rear aluminum grid lines being perpendicular to the first laser grooving bodies;
(10) printing aluminum paste on the rear surface of the silicon wafer along periphery of the rear aluminum grid lines to obtain an outer aluminum grid frame;
(11) printing front electrode paste on the front surface of the silicon wafer;
(12) sintering the silicon wafer at a high temperature to form a rear silver electrode and a front silver electrode;
(13) performing anti-LID annealing on the silicon wafer.

As a preferred example of the above embodiments, between the steps (3) and (4), the method also includes:
polishing the rear surface of the silicon wafer.

As a preferred example of the above embodiments, the step (7) also includes:
performing laser grooving in the rear surface of the silicon wafer to form a second laser grooving region, wherein the second laser grooving region includes second laser grooving units arranged vertically or horizontally, and each group of the second laser grooving units contains one or more second laser grooving bodies arranged vertically or horizontally.

The second laser grooving bodies are perpendicular to the outer aluminum grid frame.

Accordingly, the present invention also discloses a PERC solar cell module comprising a PERC solar cell and a packaging material, wherein the PERC solar cell is any of the bifacial P-type PERC solar cells described above.

Accordingly, the present invention also discloses a PERC solar system comprising a PERC solar cell, wherein the PERC solar cell is any of the bifacial P-type PERC solar cells described above.

The beneficial effects of the present invention are as follows.

In the present invention, the rear aluminum grid lines are achieved by forming the rear passivation layer on the rear surface of the silicon wafer, subsequently forming the first laser grooving region in the rear passivation layer with laser grooving, and then printing the aluminum paste along a direction perpendicular to the laser scribing direction, such that the aluminum paste is connected with the P-type silicon via the grooving region. The bifacial PERC solar cell may employ a method different from the conventional one for printing the aluminum paste, by preparing the cell grid line structure on both the front surface and the rear surface of the silicon wafer. As the width of the aluminum grid lines is much smaller than the length of the first laser grooving region, precise alignment of the aluminum paste and the first laser grooving region is not necessary, which simplifies the laser process and the printing process, lowers the difficulty in debugging the printing device, and is easy to scale-up for industrial production. Furthermore, the first laser grooving region that is not covered by the aluminum paste may increase sunlight absorption at the rear surface of the cell, thus increasing the photoelectric conversion efficiency of the cell.

Moreover, during printing, due to a high viscosity of the aluminum paste and a narrow line width of the printing screen, a broken aluminum grid line occurs occasionally. The broken aluminum grid line would lead to a black broken grid line in an image of EL (Electro-Luminescence) test. Meanwhile, the broken aluminum grid line will also affect the photoelectric conversion efficiency of the cell. For this reason, an outer aluminum grid frame is arranged at the periphery of the rear aluminum grid lines in the present invention, wherein the outer aluminum grid frame is connected with the rear aluminum grid lines and the rear silver electrode. The outer aluminum grid frame provides an additional transmission path for electrons, thus preventing the problems of broken grid lines in the EL test due to the broken aluminum grid lines and low photoelectric conversion efficiency.

A second laser grooving region may be or may not be provided below the outer aluminum grid frame. If the second laser grooving region is present, precise alignment of the aluminum paste and the second laser grooving region may be unnecessary, which simplifies the laser process and the printing process and lowers the difficulty in debugging the printing device. Furthermore, the second laser grooving region that is not covered by the aluminum paste may increase sunlight absorption at the rear surface of the cell, thus increasing the photoelectric conversion efficiency of the cell.

Therefore, the present invention is simple in structure, simple in process, low in cost, easy to popularize, and has a high photoelectric conversion efficiency.

### BRIEF DESCRIPTION OF THE DRAWINGS

FIG. 1 is a section view of a bifacial P-type PERC solar cell according to the present invention;
FIG. 2 is a schematic diagram of a first embodiment of a rear surface structure of the bifacial P-type PERC solar cell according to the present invention;
FIG. 3 is a schematic diagram of a second embodiment of a rear surface structure of the bifacial P-type PERC solar cell according to the present invention;
FIG. 4 is a schematic diagram of an embodiment of a first laser grooving region of the bifacial P-type PERC solar cell according to the present invention;
FIG. 5 is a schematic diagram of a further embodiment of a first laser grooving region of the bifacial P-type PERC solar cell according to the present invention;
FIG. 6 is a schematic diagram of a second laser grooving region of the bifacial P-type PERC solar cell according to the present invention.

### DETAILED DESCRIPTION OF THE ILLUSTRATED EMBODIMENTS

To more clearly illustrate the objectives, technical solutions and advantages of the present invention, the present invention will be further described in detail below with reference to the accompanying drawings.

An existing monofacial solar cell is provided at the rear side of the cell with an all-aluminum back electric field covering the entire rear surface of a silicon wafer. The all-aluminum back electric field functions to increase the open-circuit voltage Voc and the short-circuit current Jsc, force the minority carriers away from the surface, and decrease the recombination rate of the minority carriers, so as to increase the cell efficiency as a whole. However, as the all-aluminum back electric field is opaque, the rear side of the solar cell, which has the all-aluminum back electric field, cannot absorb light energy, and light energy can only be absorbed at the front side. The overall photoelectric conversion efficiency of the cell can hardly be improved significantly.

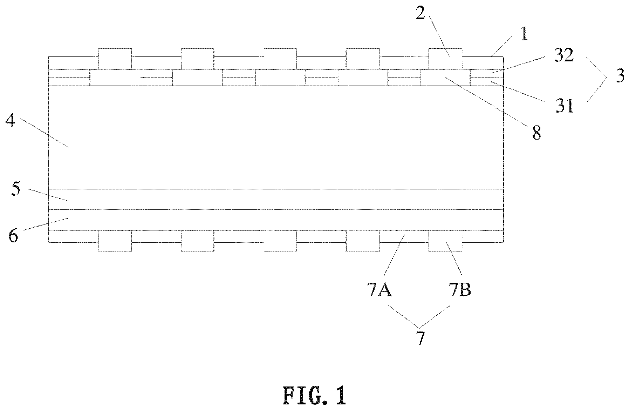

In view of the technical problem above, referring to FIG. 1, the present invention provides a bifacial P-type PERC solar cell which consecutively includes a rear silver electrode 1, a rear aluminum grid 2, a rear passivation layer 3, P-type silicon 4, an N-type emitter 5, a front silicon nitride film 6, and a front silver electrode 7. A first laser grooving region 8 is formed in the rear passivation layer 3 by laser grooving. The rear aluminum grid line 2 is connected to the P-type silicon 4 via the first laser grooving region 8. The front silver electrode 7 includes a front silver electrode busbar 7A and a front silver electrode finger 7B. The rear passivation layer 3 includes an aluminum oxide layer 31 and a silicon nitride layer 32.

The present invention improves the existing monofacial PERC solar cells and provides many back aluminum grid lines 2 in replacement of the all-aluminum back electric field. Laser grooving regions 8 are provided in the rear passivation layer 3 with a laser grooving technique, and the rear aluminum grid lines 2 are printed on these parallel-arranged laser grooving regions 8 to be in local contact with the P-type silicon 4. The rear aluminum grid lines 2 arranged in dense and parallel manner can play a role of increasing the open-circuit voltage Voc and the short-circuit current Jsc, reducing the recombination rate of the minority carriers, and thus enhancing the photoelectric conversion efficiency of the cell, to replace the all-aluminum back electric field in the existing monofacial cell structure. Moreover, since the rear surface of the silicon wafer is not completely covered by the rear aluminum grid lines 2, sunlight can be projected into the silicon wafer between the rear aluminum grid lines 2. Accordingly, the rear surface of the silicon wafer can absorb the light energy, which greatly improves the photoelectric conversion efficiency of the cell.

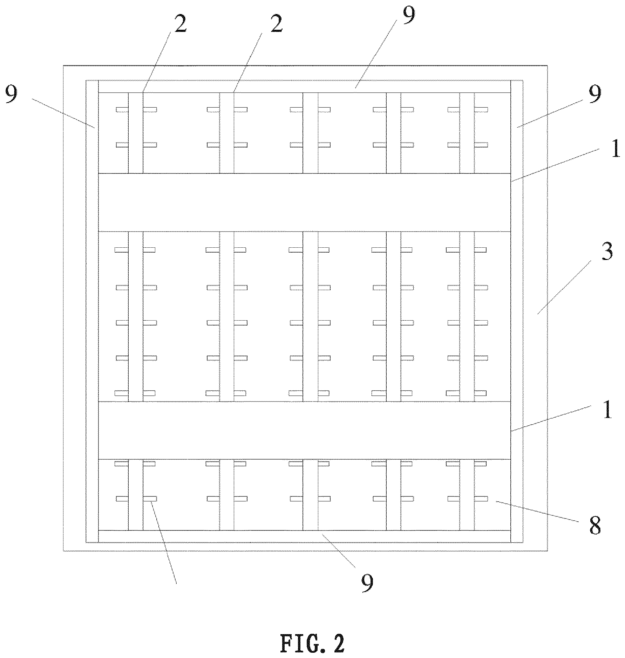

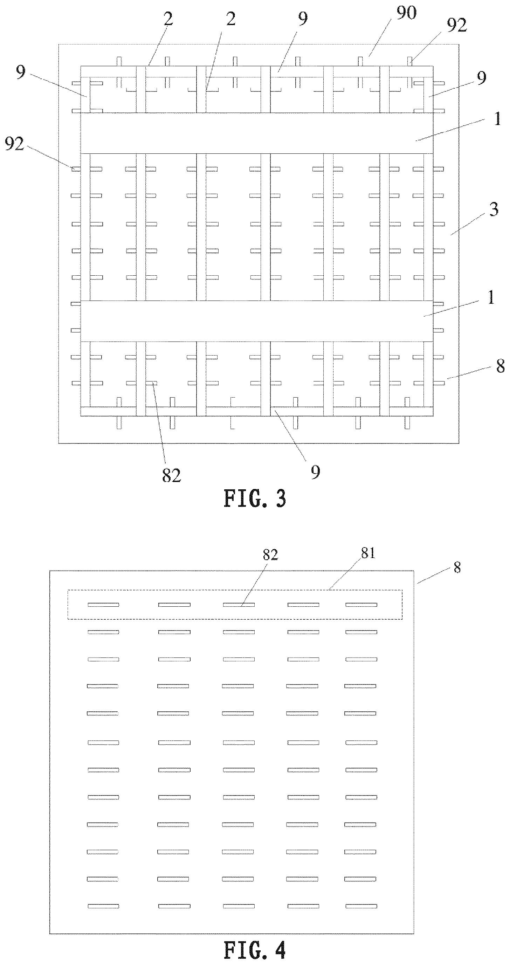

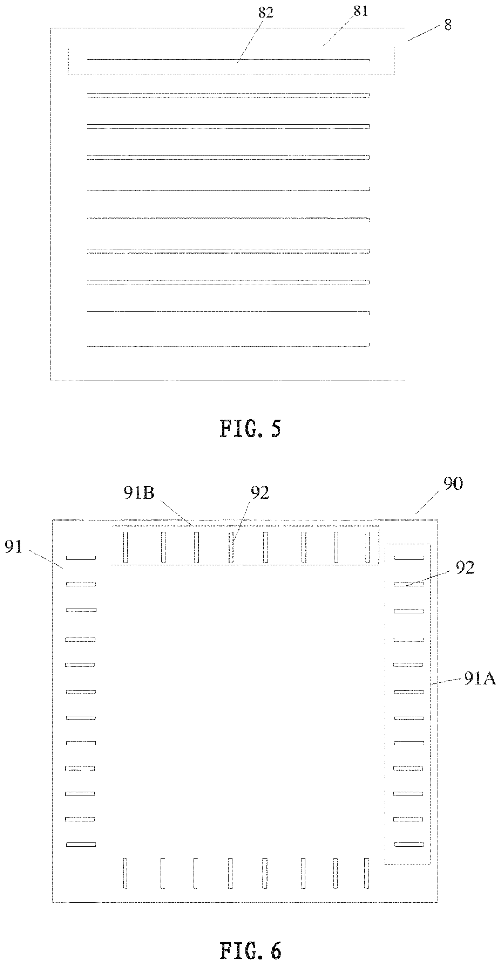

As shown in FIGS. 2 and 3, the first laser grooving region 8 includes a plurality of groups of first laser grooving units 81 arranged horizontally; a plurality of laser grooving units 81 are arranged in a vertical direction, each group of first laser grooving unit 81 includes one or more first laser grooving bodies 82 arranged horizontally. The rear aluminum grid lines 2 are perpendicular to the first laser grooving body 82. Referring to FIGS. 4 and 5, the dashed boxes shown in FIGS. 4 and 5 are the first laser grooving unit 81, and each group of first laser grooving unit 81 includes one or more first laser grooving bodies 82 arranged horizontally.

During printing, due to a high viscosity of the aluminum paste and a narrow line width of the printing screen, a broken aluminum grid line occurs occasionally. The broken aluminum grid line would lead to a black broken line in an image of EL test. Meanwhile, the broken aluminum line will also affect the photoelectric conversion efficiency of the cell. For this reason, an outer aluminum grid frame 9 is arranged at the periphery of the rear aluminum grid lines in the present invention, wherein the outer aluminum grid frame 9 is connected with the rear aluminum grid lines 2 and the rear silver electrode 1. The outer aluminum grid frame 9 provides an additional transmission path for electrons, thus preventing the problems of broken grid lines in the EL test due to the broken aluminum lines and low photoelectric conversion efficiency.

A second laser grooving region 90 may be provided below the outer aluminum grid frame 9 with reference to the first embodiment of the rear surface structure shown in FIG. 3. The outer aluminum grid frame 9 may also be provided without the second laser grooving region 90 disposed below (see the second embodiment of the rear surface structure shown in FIG. 2).

If the second laser grooving region 90 is provided, the second laser grooving region 90 includes second laser grooving units 91 arranged vertically or horizontally, and each group of the second laser grooving unit 91 contains one or more second laser grooving bodies 92 arranged vertically or horizontally. The outer aluminum grid frame 9 is perpendicular to the second laser grooving body 92. Specifically, with reference to FIG. 6, the second laser grooving region 90 includes two second laser grooving units 91A arranged vertically and two second laser grooving units 91B arranged horizontally, wherein the second laser grooving unit 91A arranged vertically includes a plurality of second laser grooving bodies 92 arranged horizontally, and the second laser grooving unit 91B arranged horizontally includes a plurality of second laser grooving bodies 92 arranged vertically.

If the second laser grooving region 90 is provided, it is unnecessary to precisely align the aluminum paste with the second laser grooving region, which simplifies the laser and printing processes and lowers the difficulty in debugging the printing device. In addition, the second laser grooving region outside the region covered by the aluminum paste can increase sunlight absorption at the rear surface of the cell and boost the photoelectric conversion efficiency of the cell.

It should be appreciated that the first laser grooving units 81 have various implementations including:
(1) Each group of the first laser grooving units 81 contains one first laser grooving body 82 arranged horizontally in which case the first laser grooving unit 81 is a continuous linear grooving region, as specifically shown in FIG. 5.
(2) Each group of the first laser grooving units 81 contains a plurality of first laser grooving bodies 82 arranged horizontally. In this case, the first laser grooving unit 81 is a discontinuous, line-segment-type linear grooving region, as specifically shown in FIG. 4. The plurality of first laser grooving bodies 82 may include two, three, four or even more first laser grooving bodies 82 and the number of the first laser grooving bodies 82 is not limited thereto.

If each group of the first laser grooving units 81 contains a plurality of first laser grooving bodies 82 arranged horizontally, there are a few possibilities as follows:
A. The plurality of first laser grooving bodies 82 arranged horizontally have the same width, length and shape and the unit of their dimensions is in the order of micron. The length may be of 50-5000 micron, but is not limited thereto. It should be noted that the first laser grooving bodies 82 may be in the same horizontal plane, or may be staggered up and down (i.e., not in the same horizontal plane). The topography of the staggered arrangement depends on production needs.
B. The plurality of first laser grooving bodies 82 arranged horizontally have the same width, length and shape and the unit of their dimensions is in the order of millimeter. The length may be of 5-600 mm, but is not limited thereto. It should be noted that the first laser grooving bodies may be in the same horizontal plane, or may be staggered up and down (i.e., not in the same horizontal plane). The topography of the staggered arrangement depends on production needs.
C. The plurality of first laser grooving bodies 82 arranged horizontally have different widths, lengths and/or shapes, which can be designed in combination based on the manufacturing requirements. It should be noted that the first laser grooving bodies may be in the same horizontal plane, or may be staggered up and down (i.e., not in the same horizontal plane). The topography of the staggered arrangement depends on production needs.

As a preferred implementation of the present invention, the first laser grooving body has a linear shape to facilitate fabrication, simplify process and lower manufacturing costs. The first laser grooving body also can be configured in other shapes, such as a curved shape, an arc shape, a wavy shape, etc. Its implementations are not limited to the embodiments presented in this invention.

The first laser grooving units 81 are arranged in parallel and the first laser grooving bodies 82 are arranged side by side in each first laser grooving unit 81, which can simplify the production process and is suitable for mass application.

Spacing between the first laser grooving units 81 is 0.5-50mm and spacing between the first laser grooving bodies 82 is 0.5-50mm in each first laser grooving unit 81.

The first laser grooving body 82 has a length of 50-5000 micron and a width of 10-500 micron. Preferably, the first laser grooving body 82 is 250-1200 micron long and 30-80 micron wide.

The length, width and spacing of the first laser grooving units 81 and the number and width of the aluminum grids are optimized based on the comprehensive consideration of contact area between the aluminum grid and the P-type silicon, shading area of the aluminum grid, and sufficient collection of electrons, with the purpose of reducing the shading area of the rear aluminum grids as much as possible, while ensuring good current output and further boosting the overall photoelectric conversion efficiency of the cell.

The number of the rear aluminum grid lines 2 is 30-500 and each rear aluminum grid line 2 has a width of 30-500 micron, wherein the width of the rear aluminum grid line 2 is much smaller than a length of the first laser grooving body 82. Preferably, the number of the rear aluminum grid lines 2 is 80-200 and each rear aluminum grid line 2 has a width of 50-300 micron.

The width of the rear aluminum grid line is much smaller than the length of the first laser grooving body, which may greatly facilitate the printing of the rear aluminum grid lines if the aluminum grid is perpendicular to the first laser grooving body. The aluminum grid can be provided within the first laser grooving region without precise alignment, which simplifies the laser and printing processes, lowers the difficulty in debugging the printing device and is easy to scale-up for industrial production.

In the present invention, the rear aluminum grid lines are achieved by forming a first laser grooving region in the rear passivation layer with laser grooving and then printing the aluminum paste in a direction perpendicular to the laser scribing direction, such that the aluminum paste is connected with the P-type silicon via the grooving region. By fabricating the cell grid line structures on the front surface and the rear surface of the silicon wafer, the bifacial PERC solar cell may employ a method different from the conventional one for printing the aluminum paste, without the need of precisely aligning the aluminum paste with the first laser grooving region. Such process is simple and easy to scale-up for industrial production. If the aluminum grid line was parallel to the first laser grooving body, it would be necessary to precisely align the aluminum paste with the first laser grooving region, which would put a high demand on the accuracy and repeatability of the printing device. As a result, the yield would be difficult to control and a lot of defective products would be produced, resulting in decreased average photoelectric conversion efficiency. With aid of the present invention, the yield can be boosted to 99.5%.

Furthermore, the rear passivation layer 3 includes an aluminum oxide layer 31 and a silicon nitride layer 32, wherein the aluminum oxide layer 31 is connected with the P-type silicon 4 and the silicon nitride layer 32 is connected with the aluminum oxide layer 31;
The silicon nitride layer 32 has a thickness of 20-500nm;
The aluminum oxide layer 31 has a thickness of 2-50nm.
Preferably, the thickness of the silicon nitride layer 32 is 100-200nm;
The thickness of the aluminum oxide layer 31 is 5-30nm.

Correspondingly, the present invention also discloses a method of preparing a bifacial P-type PERC solar cell, comprising:
S101: forming textured surfaces at a front surface and a rear surface of a silicon wafer, the silicon wafer being P-type silicon;
S102: performing diffusion on the silicon wafer to form an N-type emitter;
S103: removing phosphosilicate glass on the front surface and peripheral p-n junctions formed during the diffusion;
S104: depositing an aluminum oxide (Al₂O₃) film on the rear surface of the silicon wafer;
S105: depositing a silicon nitride film on the rear surface of the silicon wafer;
S106: depositing a silicon nitride film on the front surface of the silicon wafer;
S107: performing laser grooving in the rear surface of the silicon wafer to form a first laser grooving region, wherein the first laser grooving region includes a plurality of groups of first laser grooving units that are horizontally arranged, each group of the first laser grooving units includes one or more first laser grooving bodies that are horizontally arranged;
S108: printing a rear silver busbar electrode on the rear surface of the silicon wafer;
S109: printing aluminum paste in a direction perpendicular to the first laser grooving bodies on the rear surface of the silicon wafer to obtain rear aluminum grid, the rear aluminum grid lines being perpendicular to the first laser grooving bodies;
S110: printing aluminum paste on the rear surface of the silicon wafer along periphery of the rear aluminum grid lines to obtain an outer aluminum grid frame;
S111: printing front electrode paste on the front surface of the silicon wafer;
S112: sintering the silicon wafer at a high temperature to form a rear silver electrode and a front silver electrode;
S113: performing anti-LID annealing on the silicon wafer.

It should be noted that the sequence of S106, S104 and S 105 may be changed. S106 may be performed before S104 and S105. S109 and S110 can be combined into one step, i.e., the rear aluminum grid line and the outer aluminum grid frame are completed in a single printing.

Between S103 and S104, there is also included a step of polishing the rear surface of the silicon wafer. The present invention may be provided with or without the step of polishing the rear surface.

A second laser grooving region may be or may not be provided below the outer aluminum grid frame. If the second laser grooving region is present, the step (7) also includes:
performing laser grooving in the rear surface of the silicon wafer to form a second laser grooving region, wherein the second laser grooving region includes second laser grooving units arranged vertically or horizontally, and each group of the second laser grooving units contains one or more second laser grooving bodies arranged vertically or horizontally; the second laser grooving bodies are perpendicular to the outer aluminum grid frame.

It should also be noted that the specific parameter settings of the first laser grooving region and the rear aluminum grid line in the preparation method are identical to those described above and will not be repeated here.

Accordingly, the present invention also discloses a PERC solar cell module, which includes a PERC solar cell and a packaging material, wherein the PERC solar cell is any one of the bifacial P-type PERC solar cells described above. Specifically, as one embodiment of the PERC solar cell module, it is composed of a first high-transmittance tempered glass, a first layer of ethylene-vinyl acetate (EVA) copolymer, a PERC solar cell, a second layer of an ethylene-vinyl acetate (EVA) copolymer, and a second high-transmittance tempered glass which are sequentially connected from top to bottom.

Accordingly, the present invention also discloses a PERC solar system, which includes a PERC solar cell that is any one of the bifacial P-type PERC solar cells described above. As a preferred embedment of the PERC solar system, it includes a PERC solar cell, a rechargeable battery pack, a charge and discharge controller, an inverter, an AC power distribution cabinet, and a sun-tracking control system. The PERC solar system therein may be provided with or without a rechargeable battery pack, a charge and discharge controller, and an inverter. Those skilled in the art can adopt different settings according to actual needs.

It should be noted that in the PERC solar cell module and the PERC solar system, components other than the bifacial P-type PERC solar cell may be designed with reference to the prior art.

The present invention will be further described with reference to embodiments.

### EMBODIMENT 1

(1) forming textured surfaces at a front surface and a rear surface of a silicon wafer, the silicon wafer being P-type silicon;
(2) performing diffusion on the silicon wafer to form an N-type emitter;
(3) removing phosphosilicate glass on the front surface and peripheral p-n junctions formed during the diffusion;
(4) depositing an aluminum oxide (Al₂O₃) film on the rear surface of the silicon wafer;
(5) depositing a silicon nitride film on the rear surface of the silicon wafer;
(6) depositing a silicon nitride film on the front surface of the silicon wafer;
(7) performing laser grooving in the rear surface of the silicon wafer to form a first laser grooving region, wherein the first laser grooving region includes a plurality of groups of first laser grooving units arranged horizontally, each group of the first laser grooving units includes one or more first laser grooving bodies arranged horizontally, wherein the first laser grooving body has a length of 1000 micron and a width of 40 micron;
(8) printing a rear silver busbar electrode on the rear surface of the silicon wafer;
(9) printing aluminum paste in a direction perpendicular to the first laser grooving bodies on the rear surface of the silicon wafer to obtain rear aluminum grid, wherein the rear aluminum grid lines are perpendicular to the first laser grooving bodies, the number of the rear aluminum grid lines is 150, and the rear aluminum grid line has a width of 150 micron;
(10) printing aluminum paste on the rear surface of the silicon wafer along periphery of the rear aluminum grid lines to obtain an outer aluminum grid frame;
(11) printing front electrode paste on the front surface of the silicon wafer;
(12) sintering the silicon wafer at a high temperature to form a rear silver electrode and a front silver electrode;
(13) performing anti-LID annealing on the silicon wafer.

### EMBODIMENT 2

(1) forming textured surfaces at a front surface and a rear surface of a silicon wafer, the silicon wafer being P-type silicon;
(2) performing diffusion on the silicon wafer to form an N-type emitter;
(3) removing phosphosilicate glass on the front surface and peripheral p-n junctions formed during the diffusion and polishing the rear surface of the silicon wafer;
(4) depositing an aluminum oxide (Al₂O₃) film on the rear surface of the silicon wafer;
(5) depositing a silicon nitride film on the rear surface of the silicon wafer;
(6) depositing a silicon nitride film on the front surface of the silicon wafer;
(7) performing laser grooving in the rear surface of the silicon wafer to form first and second laser grooving regions, wherein the first laser grooving region includes a plurality of groups of horizontally-arranged first laser grooving units, each group of the first laser grooving units includes one or more horizontally-arranged first laser grooving bodies, wherein the first laser grooving body has a length of 500 micron and a width of 50 micron;
   the second laser grooving region includes two vertically arranged second laser grooving units and two horizontally arranged second laser grooving units, wherein each group of the second laser grooving units includes one or more second laser grooving bodies arranged vertically or horizontally, the second laser grooving bodies are perpendicular to the outer aluminum grid frame, and the second laser grooving body having a length of 500 micron and a width of 50 micron;
(8) printing a rear silver busbar electrode on the rear surface of the silicon wafer;
(9) printing aluminum paste in a direction perpendicular to the first laser grooving bodies on the rear surface of the silicon wafer to obtain rear aluminum grid, wherein the rear aluminum grid lines are perpendicular to the first laser grooving bodies, the number of the rear aluminum grid lines is 200, and the rear aluminum grid line has a width of 200 micron;
(10) printing aluminum paste on the rear surface of the silicon wafer along periphery of the rear aluminum grid lines to obtain an outer aluminum grid frame;
(11) printing front electrode paste on the front surface of the silicon wafer;
(12) sintering the silicon wafer at a high temperature to form a rear silver electrode and a front silver electrode;
(13) performing anti-LID annealing on the silicon wafer.

### EMBODIMENT 3

(1) forming textured surfaces at a front surface and a rear surface of a silicon wafer, the silicon wafer being P-type silicon;
(2) performing diffusion on the silicon wafer to form an N-type emitter;
(3) removing phosphosilicate glass on the front surface and peripheral p-n junctions formed during the diffusion;
(4) depositing an aluminum oxide (Al₂O₃) film on the rear surface of the silicon wafer;
(5) depositing a silicon nitride film on the rear surface of the silicon wafer;
(6) depositing a silicon nitride film on the front surface of the silicon wafer;
(7) performing laser grooving in the rear surface of the silicon wafer to form a first laser grooving region, wherein the first laser grooving region includes a plurality of groups of horizontally-arranged first laser grooving units, each group of the first laser grooving units includes one or more horizontally-arranged first laser grooving bodies, wherein the first laser grooving body has a length of 300 micron and a width of 30 micron;
(8) printing a rear silver busbar electrode on the rear surface of the silicon wafer;
(9) printing aluminum paste in a direction perpendicular to the first laser grooving bodies on the rear surface of the silicon wafer to obtain rear aluminum grid, wherein the rear aluminum grid lines are perpendicular to the first laser grooving bodies, the number of the rear aluminum grid lines is 250, and the rear aluminum grid line has a width of 250 micron;
(10) printing aluminum paste on the rear surface of the silicon wafer along periphery of the rear aluminum grid lines to obtain an outer aluminum grid frame;
(11) printing front electrode paste on the front surface of the silicon wafer;
(12) sintering the silicon wafer at a high temperature to form a rear silver electrode and a front silver electrode;
(13) performing anti-LID annealing on the silicon wafer.

### EMBODIMENT 4

(1) forming textured surfaces at a front surface and a rear surface of a silicon wafer, the silicon wafer being P-type silicon;
(2) performing diffusion on the silicon wafer to form an N-type emitter;
(3) removing phosphosilicate glass on the front surface and peripheral p-n junctions formed during the diffusion and polishing the rear surface of the silicon wafer;
(4) depositing an aluminum oxide (Al₂O₃) film on the rear surface of the silicon wafer;
(5) depositing a silicon nitride film on the rear surface of the silicon wafer;
(6) depositing a silicon nitride film on the front surface of the silicon wafer;
(7) performing laser grooving in the rear surface of the silicon wafer to form a first laser grooving region, wherein the first laser grooving region includes a plurality of groups of horizontally-arranged first laser grooving units, each group of the first laser grooving units includes one or more horizontally-arranged first laser grooving bodies, wherein the first laser grooving body has a length of 1200 micron and a width of 200 micron;
   the second laser grooving region includes two vertically arranged second laser grooving units and two horizontally arranged second laser grooving units, wherein each group of the second laser grooving units includes one or more second laser grooving bodies arranged vertically or horizontally, the second laser grooving body is perpendicular to an outer aluminum grid frame; the second laser grooving body having a length of 1200 micron and a width of 200 micron;
(8) printing a rear silver busbar electrode on the rear surface of the silicon wafer;
(9) printing aluminum paste in a direction perpendicular to the first laser grooving bodies on the rear surface of the silicon wafer to obtain rear aluminum grid, wherein the rear aluminum grid lines are perpendicular to the first laser grooving bodies, the number of the rear aluminum grid lines is 300, and the rear aluminum grid line has a width of 300 micron;
(10) printing aluminum paste on the rear surface of the silicon wafer along periphery of the rear aluminum grid lines to obtain the outer aluminum grid frame;
(11) printing front electrode paste on the front surface of the silicon wafer;
(12) sintering the silicon wafer at a high temperature to form a rear silver electrode and a front silver electrode;
(13) performing anti-LID annealing on the silicon wafer.

Finally, it should be noted that the above embodiments are only intended to illustrate the technical solutions of the present invention and are not intended to limit the protection scope of the present invention. Although the present invention has been described in detail with reference to the preferred embodiments, it should be appreciated by those skilled in the art that the technical solutions of the present invention may be modified or equivalently substituted without departing from the scope of the technical solutions of the present invention as defined by the appended claims.

## Claims

1. A bifacial P-type PERC solar cell, comprising consecutively a rear silver electrode (1), rear aluminum grid lines (2), a rear passivation layer (3), P-type silicon (4), an N-type emitter (5), a front silicon nitride film (6), and a front silver electrode (7);
**characterized in that**
a first laser grooving region (8) is formed in the rear passivation layer (3) with laser grooving, the first laser grooving region (8) is provided below the rear aluminum grid lines (2), the rear aluminum grid lines (2) are connected with the P-type silicon (4) via the first laser grooving region (8), an outer aluminum grid frame (9) is arranged at periphery of the rear aluminum grid lines (2) and is connected with the rear aluminum grid lines (2) and the rear silver electrode (1);
wherein the first laser grooving region (8) includes a plurality of groups of first laser grooving units (81) arranged horizontally, each group of the first laser grooving units (81) contains one or more first laser grooving bodies (82) arranged horizontally, and the rear aluminum grid lines (2) are perpendicular to the first laser grooving bodies (82).

2. The bifacial P-type PERC solar cell of claim 1, wherein a second laser grooving region (90) is provided below the outer aluminum grid frame (9) and includes second laser grooving units (91) arranged vertically or horizontally, each group of the second laser grooving units (91) contains one or more second laser grooving bodies (92) arranged vertically or horizontally, and the outer aluminum grid frame (9) is perpendicular to the second laser grooving bodies (92).

3. The bifacial P-type PERC solar cell of claim 1, wherein the first laser grooving units (81) are arranged in parallel;
in each of the first laser grooving units (81), the first laser grooving bodies (82) are arranged side by side, and in the same horizontal plane or staggered up and down.

4. The bifacial P-type PERC solar cell of claim 1, wherein a spacing between the first laser grooving units (81) is 0.5-50mm;
in each of the first laser grooving units (81), a spacing between the first laser grooving bodies (82) is 0.5-50mm;
the first laser grooving bodies (82) each have a length of 50-5000µm and a width of 10-500µm;
the number of the rear aluminum grid lines (2) is 30-500;
the rear aluminum grid lines (2) each have a width of 30-500µm and the width of the rear aluminum grid lines (2) is smaller than the length of the first laser grooving bodies (82).

5. The bifacial P-type PERC solar cell of claim 1, wherein the rear passivation layer (3) includes an aluminum oxide layer and a silicon nitride layer, the aluminum oxide layer is connected with the P-type silicon (4) and the silicon nitride layer is connected with the aluminum oxide layer;
the silicon nitride layer has a thickness of 20-500nm;
the aluminum oxide layer has a thickness of 2-50nm.

6. A method of preparing the bifacial P-type PERC solar cell according to any of claims 1-5, comprising:
(1) forming textured surfaces at a front surface and a rear surface of a silicon wafer, the silicon wafer being P-type silicon (4);
(2) performing diffusion on the silicon wafer to form an N-type emitter (5);
(3) removing phosphosilicate glass on the front surface and peripheral p-n junctions formed during the diffusion;
(4) depositing an aluminum oxide film on the rear surface of the silicon wafer;
(5) depositing a silicon nitride film on the rear surface of the silicon wafer;
(6) depositing a silicon nitride film on the front surface of the silicon wafer;
(7) performing laser grooving in the rear surface of the silicon wafer to form a first laser grooving region (8), wherein the first laser grooving region (8) includes a plurality of groups of first laser grooving units (81) arranged horizontally, each group of the first laser grooving units (81) contains one or more first laser grooving bodies (82) arranged horizontally;
(8) printing a rear silver busbar electrode on the rear surface of the silicon wafer;
(9) printing aluminum paste in a direction perpendicular to the first laser grooving bodies (82) on the rear surface of the silicon wafer to obtain rear aluminum grid lines (2), the rear aluminum grid lines (2) being perpendicular to the first laser grooving bodies (82);
(10) printing aluminum paste on the rear surface of the silicon wafer along periphery of the rear aluminum grid lines (2) to obtain an outer aluminum grid frame (9);
(11) printing front electrode paste on the front surface of the silicon wafer;
(12) sintering the silicon wafer at a high temperature to form a rear silver electrode (1) and a front silver electrode;
(13) performing anti-LID annealing on the silicon wafer.

7. The method of preparing the bifacial P-type PERC solar cell of claim 6, further comprising between the steps (3) and (4):
polishing the rear surface of the silicon wafer.

8. The method of preparing the bifacial P-type PERC solar cell of claim 7, wherein the step (7) further comprises:
performing laser grooving in the rear surface of the silicon wafer to form a second laser grooving region (90), wherein the second laser grooving region (90) includes second laser grooving units (91) arranged vertically or horizontally, and each group of the second laser grooving units (91) contains one or more second laser grooving bodies (92) arranged vertically or horizontally;
the second laser grooving bodies (92) are perpendicular to the outer aluminum grid frame (9).

9. A PERC solar cell module, comprising a PERC solar cell and a packaging material, wherein the PERC solar cell is the bifacial P-type PERC solar cell of any of claims 1-5.

10. A PERC solar system, comprising a PERC solar cell, wherein the PERC solar cell is the bifacial P-type PERC solar cell of any of claims 1-5.

## Patentansprüche

1. Bifaziale bzw. zweiseitige PERC-Solarzelle vom P-Typ, die hintereinander eine hintere Silberelektrode (1), hintere Aluminium-Gitterlinien (2), eine hintere Passivierungsschicht (3), P-Typ-Silizium (4), einen N-Typ-Emitter (5), eine vorderen Siliziumnitridschicht (6) und eine vordere Silberelektrode (7) aufweist;
**dadurch gekennzeichnet, dass**
ein erster Lasernutbereich bzw. Laserkerbbereich (8) in der hinteren Passivierungsschicht (3) durch Laserkerben gebildet wird, der erste Laserkerbbereich (8) unter den hinteren Aluminiumgitterlinien (2) vorgesehen ist, die hinteren Aluminiumgitterlinien (2) über den ersten Laserkerbbereich (8) mit dem P-Typ-Silizium (4) verbunden sind, ein äußerer Aluminiumgitterrahmen (9) am Umfang der hinteren Aluminiumgitterlinien (2) angeordnet ist und mit den hinteren Aluminiumgitterlinien (2) und der hinteren Silberelektrode (1) verbunden ist;
wobei der erste Laserkerbbereich (8) eine Vielzahl von Gruppen von horizontal angeordneten ersten Laserkerbeinheiten (81) umfasst, jede Gruppe der ersten Laserkerbeinheiten (81) einen oder mehrere horizontal angeordnete erste Laserkerbkörper (82) enthält und die hinteren Aluminiumgitterlinien (2) senkrecht zu den ersten Laserkerbkörpern (82) verlaufen.

2. Bifaziale PERC-Solarzelle vom P-Typ nach Anspruch 1, wobei ein zweiter Laserkerbbereich (90) unterhalb des äußeren Aluminiumgitterrahmens (9) vorgesehen ist und zweite Laserkerbeinheiten (91) enthält, die vertikal oder horizontal angeordnet sind, jede Gruppe der zweiten Laserkerbeinheiten (91) einen oder mehrere zweite Laserkerbkörper (92) enthält, die vertikal oder horizontal angeordnet sind, und der äußere Aluminiumgitterrahmen (9) senkrecht zu den zweiten Laserkerbkörpern (92) steht.

3. Bifaziale PERC-Solarzelle vom P-Typ nach Anspruch 1, wobei die ersten Laserkerbeinheiten (81) parallel angeordnet sind;
in jeder der ersten Laserkerbeinheiten (81) die ersten Laserkerbkörper (82) nebeneinander und in der gleichen horizontalen Ebene oder nach oben und unten versetzt angeordnet sind.

4. Bifaziale PERC-Solarzelle vom P-Typ nach Anspruch 1, wobei der Abstand zwischen den ersten Laserkerbeinheiten (81) 0,5-50 mm beträgt;
in jeder der ersten Laserkerbeinheiten (81) der Abstand zwischen den ersten Laserkerbkörpern (82) 0,5-50 mm beträgt;
die ersten Laserkerbkörper (82) jeweils eine Länge von 50-5000µm und eine Breite von 10-500µm haben;
die Anzahl der hinteren Aluminium-Gitterlinien (2) 30-500 beträgt;
die hinteren Aluminium-Gitterlinien (2) jeweils eine Breite von 30-500µm haben, und die Breite der hinteren Aluminium-Gitterlinien (2) kleiner als die Länge der ersten Laserkerbkörper (82) ist.

5. Bifaziale PERC-Solarzelle vom P-Typ nach Anspruch 1, wobei die hintere Passivierungsschicht (3) eine Aluminiumoxidschicht und eine Siliziumnitridschicht umfasst, die Aluminiumoxidschicht mit dem P-Typ-Silizium (4) verbunden ist und die Siliziumnitridschicht mit der Aluminiumoxidschicht verbunden ist;
die Siliziumnitridschicht eine Dicke von 20-500nm hat;
die Aluminiumoxidschicht eine Dicke von 2-50nm hat.

6. Verfahren zur Herstellung der bifazialen PERC-Solarzelle vom P-Typ nach einem der Ansprüche 1 bis 5, umfassend:
(1) Ausbilden texturierter Oberflächen an einer vorderen Oberfläche und einer hinteren Oberfläche eines Siliziumwafers, wobei der Siliziumwafer P-Typ-Silizium (4) ist;
(2) Durchführung einer Diffusion auf dem Siliziumwafer zur Bildung eines N-Emitters (5);
(3) Entfernen von Phosphorsilikatglas auf der Frontfläche und den peripheren p-n-Übergängen, die während der Diffusion entstanden sind;
(4) Abscheiden einer Aluminiumoxidschicht auf der Rückseite des Siliziumwafers;
(5) Abscheiden einer Siliziumnitridschicht auf der Rückseite des Siliziumwafers;
(6) Abscheiden einer Siliziumnitridschicht auf der Vorderseite des Siliziumwafers;
(7) Durchführen eines Laserkerbens in der hinteren Oberfläche des Siliziumwafers, um einen ersten Laserkerbbereich (8) zu bilden, wobei der erste Laserkerbbereich (8) eine Vielzahl von Gruppen von horizontal angeordneten ersten Laserkerbeinheiten (81) enthält, wobei jede Gruppe der ersten Laserkerbeinheiten (81) einen oder mehrere horizontal angeordnete erste Laserkerbkörper (82) enthält;
(8) Drucken einer hinteren Silber-Busbar-Elektrode auf die Rückseite des Siliziumwafers;
(9) Drucken von Aluminiumpaste in einer Richtung senkrecht zu den ersten Laserkerbkörpern (82) auf die hintere Oberfläche des Siliziumwafers, um hintere Aluminiumgitterlinien (2) zu erhalten, wobei die hinteren Aluminiumgitterlinien (2) senkrecht zu den ersten Laserkerbkörpern (82) sind;
(10) Drucken von Aluminiumpaste auf die Rückseite des Siliziumwafers entlang des Umfangs der hinteren Aluminiumgitterlinien (2), um einen äußeren Aluminiumgitterrahmen (9) zu erhalten;
(11) Drucken von Frontelektrodenpaste auf die Vorderseite des Siliziumwafers;
(12) Sintern des Siliziumwafers bei einer hohen Temperatur, um eine hintere Silberelektrode (1) und eine vordere Silberelektrode zu bilden;
(13) Durchführung eines Anti-LID-Glühens auf dem Siliziumwafer.

7. Verfahren zur Herstellung der bifazialen PERC-Solarzelle vom P-Typ nach Anspruch 6, das außerdem zwischen den Schritten (3) und (4) umfasst:
Polieren der Rückseite des Siliziumwafers.

8. Verfahren zur Herstellung der bifazialen PERC-Solarzelle vom P-Typ nach Anspruch 7, wobei der Schritt (7) ferner umfasst:
Durchführen eines Laserkerbens in der hinteren Oberfläche des Siliziumwafers, um einen zweiten Laserkerbbereich (90) zu bilden, wobei der zweite Laserkerbbereich (90) zweite Laserkerbeinheiten (91) enthält, die vertikal oder horizontal angeordnet sind, und jede Gruppe der zweiten Laserkerbeinheiten (91) einen oder mehrere zweite Laserkerbkörper (92) enthält, die vertikal oder horizontal angeordnet sind;
wobei die zweiten Laserkerbkörper (92) senkrecht zum äußeren Aluminiumgitterrahmen (9) stehen.

9. PERC-Solarzellenmodul, umfassend eine PERC-Solarzelle und ein Verpackungsmaterial, wobei die PERC-Solarzelle die bifaziale PERC-Solarzelle vom P-Typ nach einem der Ansprüche 1 bis 5 ist.

10. PERC-Solarsystem, umfassend eine PERC-Solarzelle, wobei die PERC-Solarzelle die bifaziale PERC-Solarzelle vom P-Typ nach einem der Ansprüche 1 bis 5 ist.

## Revendications

1. Cellule solaire PERC bifaciale de type P, comprenant consécutivement une électrode arrière en argent (1), des lignes de grille arrière en aluminium (2), une couche de passivation arrière (3), du silicium de type P (4), un émetteur de type N (5), un film de nitrure de silicium avant (6), et une électrode avant en argent (7) ;
**caractérisé en ce que**
une première région de rainurage au laser (8) est formée dans la couche de passivation arrière (3) par rainurage au laser, la première région de rainurage au laser (8) est prévue sous les lignes de grille en aluminium arrière (2), les lignes de grille en aluminium arrière (2) sont connectées au silicium de type P (4) via la première région de rainurage au laser (8), un cadre de grille en aluminium extérieur (9) est disposé à la périphérie des lignes de grille en aluminium arrière (2) et est connecté aux lignes de grille en aluminium arrière (2) et à l'électrode en argent arrière (1) ;
dans laquelle la première région de rainurage laser (8) comprend une pluralité de groupes de premières unités de rainurage laser (81) disposées horizontalement, chaque groupe des premières unités de rainurage laser (81) contient un ou plusieurs premiers corps de rainurage laser (82) disposés horizontalement, et les lignes de grille en aluminium arrière (2) sont perpendiculaires aux premiers corps de rainurage laser (82).

2. Cellule solaire PERC bifaciale de type P selon la revendication 1, dans laquelle une seconde région de rainurage laser (90) est prévue en dessous du cadre de grille en aluminium extérieur (9) et comprend des secondes unités de rainurage laser (91) disposées verticalement ou horizontalement, chaque groupe des secondes unités de rainurage laser (91) contient un ou plusieurs seconds corps de rainurage laser (92) disposés verticalement ou horizontalement, et le cadre de grille en aluminium extérieur (9) est perpendiculaire aux seconds corps de rainurage laser (92).

3. Cellule solaire PERC bifaciale de type P de la revendication 1, dans laquelle les premières unités de rainurage laser (81) sont disposées en parallèle ;
dans chacune des premières unités de rainurage laser (81), les premiers corps de rainurage laser (82) sont disposés côte à côte, et dans le même plan horizontal ou décalés vers le haut et vers le bas.

4. Cellule solaire PERC bifaciale de type P de la revendication 1, dans laquelle un espacement entre les premières unités de rainurage laser (81) est de 0,5 à 50 mm ;
dans chacune des premières unités de rainurage laser (81), un espacement entre les premiers corps de rainurage laser (82) est de 0,5 à 50 mm ;
les premiers corps de rainurage laser (82) présentent chacun une longueur de 50-5000µm et une largeur de 10-500µm ;
le nombre de lignes de la grille d'aluminium arrière (2) est de 30-500 ;
les lignes de grille en aluminium arrière (2) ont chacune une largeur de 30-500µm et la largeur des lignes de grille en aluminium arrière (2) est inférieure à la longueur des premiers corps de rainurage laser (82).

5. Cellule solaire PERC bifaciale de type P de la revendication 1, dans laquelle la couche de passivation arrière (3) comprend une couche d'oxyde d'aluminium et une couche de nitrure de silicium, la couche d'oxyde d'aluminium est reliée au silicium de type P (4) et la couche de nitrure de silicium est reliée à la couche d'oxyde d'aluminium ;
la couche de nitrure de silicium a une épaisseur de 20 à 500 nm ;
la couche d'oxyde d'aluminium a une épaisseur de 2-50nm.

6. Procédé de préparation de la cellule solaire PERC bifaciale de type P selon l'une quelconque des revendications 1 à 5, comprenant :
(1) former des surfaces texturées sur une surface avant et une surface arrière d'une plaquette de silicium, la plaquette de silicium étant du silicium de type P (4) ;
(2) réaliser une diffusion sur la tranche de silicium pour former un émetteur de type N (5);
(3) enlever le verre de phosphosilicate sur la surface frontale et les jonctions p-n périphériques formées pendant la diffusion ;
(4) déposer d'un film d'oxyde d'aluminium sur la surface arrière de la plaquette de silicium ;
(5) déposer d'un film de nitrure de silicium sur la surface arrière de la plaquette de silicium ;
(6) déposer d'un film de nitrure de silicium sur la surface avant de la plaquette de silicium ;
(7) réaliser un rainurage laser dans la surface arrière de la tranche de silicium pour former une première région de rainurage laser (8), dans laquelle la première région de rainurage laser (8) comprend une pluralité de groupes de premières unités de rainurage laser (81) disposées horizontalement, chaque groupe des premières unités de rainurage laser (81) contient un ou plusieurs premiers corps de rainurage laser (82) disposés horizontalement ;
(8) imprimer d'une électrode arrière à barres d'argent sur la surface arrière de la tranche de silicium ;
(9) imprimer de la pâte d'aluminium dans une direction perpendiculaire aux premiers corps de rainurage laser (82) sur la surface arrière de la tranche de silicium pour obtenir des lignes de grille d'aluminium arrière (2), les lignes de grille d'aluminium arrière (2) étant perpendiculaires aux premiers corps de rainurage laser (82) ;
(10) imprimer de la pâte d'aluminium sur la surface arrière de la plaquette de silicium le long de la périphérie des lignes de grille d'aluminium arrière (2) pour obtenir un cadre de grille d'aluminium extérieur (9) ;
(11) imprimer de la pâte d'électrode avant sur la surface avant de la plaquette de silicium ;
(12) fritter la tranche de silicium à une température élevée pour former une électrode arrière en argent (1) et une électrode avant en argent ;
(13) effectuer un recuit anti-LID sur la tranche de silicium.

7. Procédé de préparation de la cellule solaire PERC bifaciale de type P de la revendication 6, comprenant en outre entre les étapes (3) et (4) :
polir de la surface arrière de la plaquette de silicium.

8. Procédé de préparation de la cellule solaire PERC bifaciale de type P de la revendication 7, dans lequel l'étape (7) comprend en outre :
effectuer un rainurage au laser dans la surface arrière de la tranche de silicium pour former une seconde région de rainurage au laser (90), dans laquelle la seconde région de rainurage au laser (90) comprend des secondes unités de rainurage au laser (91) disposées verticalement ou horizontalement, et chaque groupe des secondes unités de rainurage au laser (91) contient un ou plusieurs seconds corps de rainurage au laser (92) disposés verticalement ou horizontalement ;
les seconds corps de rainurage laser (92) sont perpendiculaires au cadre extérieur de la grille en aluminium (9).

9. Module de cellule solaire PERC, comprenant une cellule solaire PERC et un matériau d'emballage, dans lequel la cellule solaire PERC est la cellule solaire PERC bifaciale de type P de l'une quelconque des revendications 1 à 5.

10. Système solaire PERC, comprenant une cellule solaire PERC, dans lequel la cellule solaire PERC est la cellule solaire PERC bifaciale de type P de l'une quelconque des revendications 1-5.
